# EUROPEAN PATENT APPLICATION

(11) **EP 4 783 231 A1**
(43) Date of publication of application: **29.07.2026**
(21) Application number: 24868299.9
(22) Date of filing: 19.09.2024
(51) Int. Cl.: H01L 21/304, C11D 1/62, C11D 3/20, C11D 3/28, C23F 1/00, C23G 1/16, G03F 7/40, G03F 7/42

(54) **COMPOSITION AND KIT, AND METHOD FOR REMOVING RESIST AND METHOD FOR MANUFACTURING ELECTRONIC SUBSTRATE EACH USING THESE**

(30) Priority: 21.09.2023 JP 2023154075
(71) Applicant: MITSUBISHI GAS CHEMICAL COMPANY, INC., Chiyoda-ku Tokyo 100-8324 (JP)
(72) Inventor: HOMMO, Yoshihiro, Taichung City, 435059 (TW); OIE, Toshiyuki, deceased (TW); YANG, Chih-Liang, Taichung City, 435059 (TW)
(74) Representative: Müller-Boré & Partner Patentanwälte PartG mbB
(86) International application number: PCT/JP2024/033398
(87) International publication number: WO 2025/063222

(57) **Abstract**

Provided are a composition and the like that can suppress oxidation of copper wiring after resist removal. A composition that includes a basic compound; and a copper surface protective agent including at least one selected from the group consisting of an ammonium salt represented by the following formula (1), a heteroaryl salt having a substituted or unsubstituted alkyl group having 5 to 30 carbon atoms, and a substituted or unsubstituted thiol having 5 to 30 carbon atoms; and that has a pH of 13 or higher. In the formula (1), R¹ is a substituted or unsubstituted alkyl group having 5 to 30 carbon atoms, a substituted or unsubstituted alkyl(poly)heteroalkylene group having 5 to 30 carbon atoms, or a substituted or unsubstituted aryl(poly)heteroalkylene group having 7 to 30 carbon atoms; R² is each independently a substituted or unsubstituted alkyl group having 1 to 30 carbon atoms, or a substituted or unsubstituted aryl group having 6 to 30 carbon atoms; and X is a halide ion, a hydroxide ion, an organic sulfonate ion, a tetrafluoroborate anion, or a hexafluorophosphate anion.

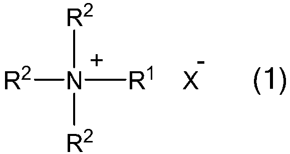

## Description

### Technical Field

The present invention relates to a composition and a kit, and a method for manufacturing an electronic substrate and a method for removing resist each using these.

### Background Art

In recent years, electronic devices have been increasingly miniaturized and made multifunctional. Even in electronic substrates having copper wiring used in such electronic devices, miniaturization and higher functionality are required.

As a method for manufacturing electronic substrates satisfying such requirements, methods using resist are known. For example, the method includes: a coating film formation step of forming a coating film of a photosensitive resin on a substrate; a patterning step in which the resulting coating film is exposed and developed for patterning to prepare a substrate having a resist; a copper wiring formation step of forming copper wiring on the substrate exposed by development by plating or the like, thereby preparing a substrate having copper wiring and resist disposed between the copper wirings; and a resist removing step of removing the resist using a cleaning agent.

As the aforementioned method for manufacturing an electronic substrate, for example, Patent Literature 1 discloses an invention relating to a cleaning method including a step of stripping a resin mask adhered to an object to be cleaned using a cleaning composition containing an alkali agent (component A), an organic solvent (component B), and water (component C), wherein the Hansen solubility parameter coordinates of the component B are within a predetermined range, and the cleaning composition has an electrical conductivity of 11 S/m or more.

Patent Literature 1 discloses that a cleaning method having excellent resin mask (resist) removability is provided.

### Citation List

### Patent Literature

Patent Literature 1: International Publication No. WO2020/022491

### Summary of Invention

### Technical Problem

Meanwhile, it is known that copper can form copper oxide through oxidation with oxygen in the air, etc. For example, when the resist is removed using the cleaning composition described in Patent Literature 1, the contact area with oxygen in the air, etc. increases as the copper wiring is exposed, making copper oxide more likely to form. For this reason, in the manufacturing process of electronic substrates, it has sometimes been difficult to store substrates for a long period after resist removal.

Accordingly, the present invention provides a composition and the like that can suppress oxidation of copper wiring after resist removal.

### Solution to Problem

The present invention is, for example, as follows.
[1] A composition comprising:
   a basic compound; and
   a copper surface protective agent comprising at least one selected from the group consisting of an ammonium salt represented by the following formula (1): 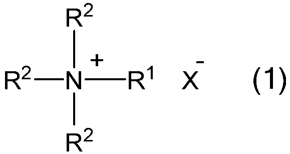
   (wherein R¹ is a substituted or unsubstituted alkyl group having 5 to 30 carbon atoms, a substituted or unsubstituted alkyl(poly)heteroalkylene group having 5 to 30 carbon atoms, or a substituted or unsubstituted aryl(poly)heteroalkylene group having 7 to 30 carbon atoms;
   R² is each independently a substituted or unsubstituted alkyl group having 1 to 30 carbon atoms, or a substituted or unsubstituted aryl group having 6 to 30 carbon atoms; and
   X is a halide ion, a hydroxide ion, an organic sulfonate ion, a tetrafluoroborate anion, or a hexafluorophosphate anion), a heteroaryl salt having a substituted or unsubstituted alkyl group having 5 to 30 carbon atoms, and a substituted or unsubstituted thiol having 5 to 30 carbon atoms,
   wherein the composition has a pH of 13 or higher.
[2] The composition according to [1] above, wherein the basic compound comprises a strongly basic compound.
[3] The composition according to [2] above, wherein the strongly basic compound comprises an inorganic strongly basic compound.
[4] The composition according to [2] or [3] above, wherein the content of the strongly basic compound is 3 to 10% by mass based on the total mass of the composition.
[5] The composition according to any one of [2] to [4] above, wherein the basic compound further comprises a weakly basic compound.
[6] The composition according to any one of [1] to [5] above, wherein the copper surface protective agent comprises a heteroaryl salt having a substituted or unsubstituted alkyl group having 8 to 20 carbon atoms.
[7] The composition according to [6] above, wherein the copper surface protective agent comprises a pyridinium salt having a substituted or unsubstituted alkyl group having 14 to 20 carbon atoms.
[8] The composition according to [6] above, wherein the copper surface protective agent comprises an imidazolium salt having a substituted or unsubstituted alkyl group having 8 to 14 carbon atoms.
[9] The composition according to any one of [1] to [8] above, wherein the copper surface protective agent comprises a substituted or unsubstituted thiol having 8 to 20 carbon atoms.
[10] The composition according to any one of [1] to [9] above, wherein the content of the copper surface protective agent is 0.07 to 0.5% by mass based on the total mass of the composition.
[11] The composition according to any one of [1] to [10] above, further comprising an organic solvent.
[12] A method for manufacturing an electronic substrate, comprising a step of bringing the composition according to any one of [1] to [11] above into contact with a substrate comprising copper wiring and a resist disposed between the copper wirings, thereby removing the resist, and forming a protective layer on the surface of the copper wiring.
[13] A method for removing resist, comprising a step of bringing the composition according to any one of [1] to [11] above into contact with a substrate comprising copper wiring and a resist disposed between the copper wirings, thereby removing the resist, and forming a protective layer on the surface of the copper wiring.
[14] A kit for use in the method for manufacturing an electronic substrate according to [12] above,
   the kit comprising a first solution comprising a basic compound and a second solution comprising a copper surface protective agent, wherein the first and second solutions are kept in an unmixed state and mixed at the time of use.
[15] A kit for use in the method for removing resist according to [13] above,
   the kit comprising a first solution comprising a basic compound and a second solution comprising a copper surface protective agent, wherein the first and second solutions are kept in an unmixed state and mixed at the time of use.

### Advantageous Effects of Invention

The present invention provides a composition and the like that can suppress oxidation of copper wiring after resist removal.

### Description of Embodiments

Hereinafter, embodiments of the present invention will be described in detail.

### 1. Composition

The composition according to the present invention comprises a basic compound, and a copper surface protective agent comprising at least one selected from the group consisting of an ammonium salt represented by formula (1), a heteroaryl salt having a substituted or unsubstituted alkyl group having 5 to 30 carbon atoms, and a substituted or unsubstituted thiol having 5 to 30 carbon atoms. In this case, the pH of the composition according to the present invention is 13 or higher.

The composition according to the present invention can remove resist because it contains a basic compound. Furthermore, since the composition according to the present invention contains a copper surface protective agent, oxidation of copper wiring after resist removal can be suppressed.

### [Basic Compound]

The basic compound functions to promote the removal of resist. For example, the composition according to the present invention has a pH of 13 or higher due to the presence of the basic compound. The composition according to the present invention dissolves or swells the resin that constitutes the resist, thereby reducing the adhesion force between the substrate and the resin, resulting in removal of the resist from the substrate.

The basic compound includes a strongly basic compound and a weakly basic compound. In the present description, a "strongly basic compound" means a compound having a degree of ionization of 0.9 or more in water at room temperature (23°C). A "weakly basic compound" means a compound having a degree of ionization of less than 0.9 in water at room temperature (23°C).

### (Strongly basic compound)

The strongly basic compound is not particularly limited, but examples include inorganic strongly basic compounds and organic strongly basic compounds.

Examples of inorganic strongly basic compounds include, but are not limited to, strongly basic alkali metal compounds such as lithium hydroxide, sodium hydroxide, and potassium hydroxide; and strongly basic alkaline earth metal compounds such as calcium hydroxide.

Examples of organic strongly basic compounds include, but are not limited to, quaternary ammonium compounds represented by the following formula (2): 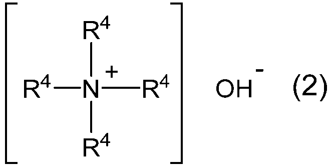 wherein R⁴ is each independently an alkyl group having 1 to 4 carbon atoms or a hydroxyalkyl group having 1 to 4 carbon atoms.

Examples of alkyl groups having 1 to 4 carbon atoms include a methyl group, an ethyl group, a propyl group, an isopropyl group, and a butyl group.

Examples of hydroxyalkyl groups having 1 to 4 carbon atoms include a hydroxymethyl group, a hydroxyethyl group, a hydroxypropyl group, and a hydroxybutyl group.

Specific examples of compounds represented by the formula (2) include tetramethylammonium hydroxide (TMAH), tetraethylammonium hydroxide, tetrapropylammonium hydroxide, 2-hydroxyethyltrimethylammonium hydroxide (choline), 2-hydroxyethyltriethylammonium hydroxide, 2-hydroxyethyltripropylammonium hydroxide, 2-hydroxypropyltrimethylammonium hydroxide, 2-hydroxypropyltriethylammonium hydroxide, 2-hydroxypropyltripropylammonium hydroxide, bis(2-hydroxyethyl)dimethylammonium hydroxide, bis(2-hydroxyethyl)diethylammonium hydroxide, bis(2-hydroxyethyl)dipropylammonium hydroxide, tris(2-hydroxyethyl)methylammonium hydroxide, tris(2-hydroxyethyl)ethylammonium hydroxide, tris(2-hydroxyethyl)propylammonium hydroxide, tetrakis(2-hydroxyethyl)ammonium hydroxide, and tetrakis(2-hydroxypropyl)ammonium hydroxide.

The aforementioned strongly basic compound may be used alone or in combination of two or more.

### (Weakly basic compound)

The weakly basic compound is not particularly limited, but examples include inorganic weakly basic compounds and organic weakly basic compounds.

Examples of inorganic weakly basic compounds include, but are not limited to, weakly basic alkali metal compounds such as sodium carbonate, potassium carbonate, sodium silicate, and potassium silicate; weakly basic alkaline earth metal compounds such as magnesium hydroxide, magnesium carbonate, calcium carbonate, calcium silicate, and magnesium silicate; transition metal compounds such as copper hydroxide and iron hydroxide; and ammonia.

Examples of organic weakly basic compounds include, but are not limited to, amine compounds represented by the following formula (3) or (4): 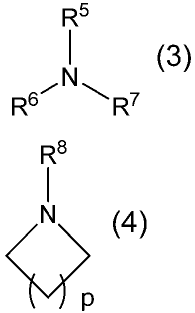 wherein R⁵ is a hydrogen atom, an alkyl group having 1 to 4 carbon atoms, or an aminoalkyl group having 1 to 4 carbon atoms; R⁶ is a hydrogen atom, an alkyl group having 1 to 4 carbon atoms, or a hydroxyalkyl group having 1 to 4 carbon atoms; and R⁷ is a hydroxyalkyl group having 1 to 4 carbon atoms or an aminoalkyl group having 1 to 6 carbon atoms.

R⁸ is an alkyl group having 1 to 4 carbon atoms, a hydroxyalkyl group having 1 to 4 carbon atoms, or an aminoalkyl group having 1 to 4 carbon atoms; p is an integer of 1 or more, preferably 1 to 6, and more preferably 2 or 3.

Examples of alkyl groups having 1 to 4 carbon atoms include a methyl group, an ethyl group, a propyl group, an isopropyl group, and a butyl group.

Examples of hydroxyalkyl groups having 1 to 4 carbon atoms include a hydroxymethyl group, a hydroxyethyl group, a hydroxypropyl group, and a hydroxybutyl group.

Examples of aminoalkyl groups having 1 to 4 carbon atoms include an aminomethyl group, an aminoethyl group, an aminopropyl group, and an aminobutyl group.

Specific examples of amine compounds represented by the formula (3) include monoethanolamine, monoisopropanolamine, N-methylmonoethanolamine, N-methylisopropanolamine, N-ethylmonoethanolamine, N-ethylisopropanolamine, diethanolamine, diisopropanolamine, N-dimethylmonoethanolamine, N-dimethylmonoisopropanolamine, N-methyldiethanolamine, N-methyldiisopropanolamine, N-diethylmonoethanolamine, N-diethylmonoisopropanolamine, N-ethyldiethanolamine, N-ethyldiisopropanolamine, N-(β-aminoethyl)ethanolamine, N-(β-aminoethyl)isopropanolamine, N-(β-aminoethyl)diethanolamine, and N-(β-aminoethyl)diisopropanolamine.

Specific examples of amine compounds represented by the formula (4) include 1-methylpiperazine, 1-(2-hydroxyethyl)pyrrolidine, and 1-(2-hydroxyethyl)piperazine.

The aforementioned weakly basic compound may be used alone or in combination of two or more.

In one embodiment, from the viewpoint of making the pH of the composition 13 or higher, the basic compound preferably includes a strongly basic compound. From the viewpoint of suppressing oxidation of copper wiring more effectively, the basic compound more preferably includes an inorganic strongly basic compound, further preferably a strongly basic alkali metal compound, and particularly preferably potassium hydroxide or sodium hydroxide.

In one embodiment, from the viewpoint of improving resist strippability, it is preferable that the basic compound further includes a weakly basic compound in addition to a strongly basic compound. The basic compound more preferably includes an organic weakly basic compound, particularly preferably an amine compound represented by the formula (3), especially preferably at least one selected from the group consisting of monoethanolamine, monoisopropanolamine, N-methylmonoethanolamine, N-methylisopropanolamine, N-ethylmonoethanolamine, N-ethylisopropanolamine, N-dimethylmonoethanolamine, N-dimethylmonoisopropanolamine, N-diethylmonoethanolamine, N-diethylmonoisopropanolamine, N-(β-aminoethyl)ethanolamine, and N-(β-aminoethyl)isopropanolamine, and most preferably at least one selected from the group consisting of monoethanolamine, N-methylmonoethanolamine, N-ethylmonoethanolamine, N-dimethylmonoethanolamine, N-diethylmonoethanolamine, and N-(β-aminoethyl)ethanolamine.

The content of the basic compound is preferably 0.1 to 50% by mass, more preferably 1 to 20% by mass, further preferably 3 to 20% by mass, and particularly preferably 3 to 10% by mass based on the total mass of the composition.

In one embodiment, the content of the strongly basic compound is preferably 0.1 to 20% by mass, more preferably 0.5 to 10% by mass, further preferably 1 to 10% by mass, particularly preferably 3 to 10% by mass, and most preferably 3 to 6% by mass based on the total mass of the composition from the viewpoint of suppressing oxidation of copper wiring more effectively.

In one embodiment, the content of the weakly basic compound is preferably 5 to 40% by mass, more preferably 10 to 40% by mass, further preferably 10 to 30% by mass, and particularly preferably 15 to 25% by mass based on the total mass of the composition.

### [Copper surface protective agent]

The copper surface protective agent functions by adsorbing onto copper wiring, thereby forming a protective film and suppressing oxidation of the copper wiring. The effect of suppressing oxidation of the copper wiring is considered to result, for example, from adsorption of a cationic copper surface protective agent onto the copper surface when the pH of the composition is 13 or higher and the zeta (ς) potential of the copper surface becomes negative, or from adsorption of a copper surface protective agent having thiol onto the copper surface due to the high affinity of sulfur for copper. Even when the composition according to the present invention exerts the effects of the present invention for reasons other than those described above, the composition is included within the scope of the present invention.

The copper surface protective agent includes at least one selected from the group consisting of an ammonium salt represented by the formula (1), a heteroaryl salt having a substituted or unsubstituted alkyl group having 5 to 30 carbon atoms, and a substituted or unsubstituted thiol having 5 to 30 carbon atoms.

### (Ammonium salt represented by formula (1))

The ammonium salt according to the present invention is represented by the following formula (1): 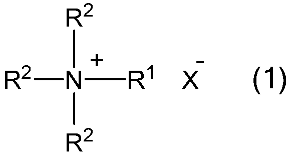 wherein R¹ is a substituted or unsubstituted alkyl group having 5 to 30 carbon atoms, a substituted or unsubstituted alkyl(poly)heteroalkylene group having 5 to 30 carbon atoms, or a substituted or unsubstituted aryl(poly)heteroalkylene group having 7 to 30 carbon atoms.

Examples of alkyl groups having 5 to 30 carbon atoms include, but are not limited to, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an icosyl group, a docosyl group, a tetracosyl group, a hexacosyl group, an octacosyl group, and a triacontyl group.

When the substituted or unsubstituted alkyl group having 5 to 30 carbon atoms has a substituent (a substituted alkyl group having 5 to 30 carbon atoms), the substituent is not particularly limited, but examples include a halogen atom such as a fluorine atom, a chlorine atom, a bromine atom, or an iodine atom; an aryl group having 6 to 20 carbon atoms such as a phenyl group or a naphthyl group; an alkoxy group having 1 to 6 carbon atoms such as a methoxy group, an ethoxy group, or a propyloxy group; a hydroxy group; a cyano group; and a nitro group. The number of substituents may be one, or two or more. In addition, the substituted alkyl group having 5 to 30 carbon atoms refers to a group in which the total number of carbon atoms of the substituent(s) and the alkyl group is 5 to 30.

The alkyl(poly)heteroalkylene group having 5 to 30 carbon atoms is represented by -(CₙH₂ₙ-Z-)ₘ-R³. In this case, n is each independently 1 to 5, preferably 1 to 3, and more preferably 1 or 2. m is 1 to 5, preferably 1 or 2. Z is each independently an oxygen atom (O), a sulfur atom (S), or a phosphorus atom (P), preferably an oxygen atom (O). R³ is an alkyl group having 1 to 30 carbon atoms, and examples include a methyl group, an ethyl group, a propyl group, an isopropyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, and an icosyl group.

When the substituted or unsubstituted alkyl(poly)heteroalkylene group having 5 to 30 carbon atoms has a substituent (a substituted alkyl(poly)heteroalkylene group having 5 to 30 carbon atoms), the substituent is not particularly limited, but examples include a halogen atom such as a fluorine atom, a chlorine atom, a bromine atom, or an iodine atom; an aryl group having 6 to 20 carbon atoms such as a phenyl group or a naphthyl group; an alkoxy group having 1 to 6 carbon atoms such as a methoxy group, an ethoxy group, or a propyloxy group; a hydroxy group; a cyano group; and a nitro group. The substituent usually replaces a hydrogen atom of R³. The number of substituents may be one, or two or more. In addition, the substituted alkyl(poly)heteroalkylene group having 5 to 30 carbon atoms refers to a group in which the total number of carbon atoms of the substituent(s) and the alkyl(poly)heteroalkylene group is 5 to 30.

The aryl(poly)heteroalkylene group having 7 to 30 carbon atoms is represented by -(CₙH₂ₙ-Z-)ₘ-Ar. In this case, n is each independently 1 to 5, preferably 1 to 3, and more preferably 1 or 2. m is 1 to 5, preferably 1 or 2. Z is each independently an oxygen atom (O), a sulfur atom (S), or a phosphorus atom (P), preferably an oxygen atom (O). Ar is an aryl group having 6 to 18 carbon atoms, and examples include a phenyl group, a naphthyl group, and an anthracenyl group.

When the substituted or unsubstituted aryl(poly)heteroalkylene group having 7 to 30 carbon atoms has a substituent (a substituted aryl(poly)heteroalkylene group having 7 to 30 carbon atoms), the substituent is not particularly limited, but examples include a halogen atom such as a fluorine atom, a chlorine atom, a bromine atom, or an iodine atom; an alkyl group having 1 to 10 carbon atoms such as a methyl group, an ethyl group, a propyl group, an isopropyl group, a butyl group, a 1,1-dimethylbutyl group, a 2,2-dimethylbutyl group, or a 1,1,3,3-tetramethylbutyl group; an alkoxy group having 1 to 6 carbon atoms such as a methoxy group, an ethoxy group, or a propyloxy group; a hydroxy group; a cyano group; and a nitro group. The substituent usually replaces a hydrogen atom of Ar. The number of substituents may be one, or two or more. In addition, the substituted aryl(poly)heteroalkylene group having 7 to 30 carbon atoms refers to a group in which the total number of carbon atoms of the substituent(s) and the aryl(poly)heteroalkylene group is 7 to 30.

In one embodiment, R¹ is preferably a substituted or unsubstituted alkyl group having 5 to 30 carbon atoms, more preferably a substituted or unsubstituted alkyl group having 8 to 20 carbon atoms, further preferably an alkyl group having 10 to 20 carbon atoms, particularly preferably an alkyl group having 14 to 20 carbon atoms, and most preferably an alkyl group having 16 to 20 carbon atoms.

R² is each independently a substituted or unsubstituted alkyl group having 1 to 30 carbon atoms or a substituted or unsubstituted aryl group having 6 to 30 carbon atoms.

Examples of alkyl groups having 1 to 30 carbon atoms include, but are not limited to, a methyl group, an ethyl group, a propyl group, an isopropyl group, a butyl group, an isobutyl group, a sec-butyl group, a tert-butyl group, a pentyl group, a hexyl group, a heptyl group, an octyl group, a nonyl group, a decyl group, a dodecyl group, a tetradecyl group, a hexadecyl group, an octadecyl group, a nonadecyl group, and an icosyl group.

When the substituted or unsubstituted alkyl group having 1 to 30 carbon atoms has a substituent (a substituted alkyl group having 1 to 30 carbon atoms), the substituent is a halogen atom such as a fluorine atom, a chlorine atom, a bromine atom, or an iodine atom; an aryl group having 6 to 20 carbon atoms such as a phenyl group or a naphthyl group; an alkoxy group having 1 to 6 carbon atoms such as a methoxy group, an ethoxy group, or a propyloxy group; a hydroxy group; a cyano group; or a nitro group. The number of substituents may be one, or two or more. In addition, the substituted alkyl group having 1 to 30 carbon atoms refers to a group in which the total number of carbon atoms of the substituent(s) and the alkyl group is 1 to 30.

Examples of aryl groups having 6 to 30 carbon atoms include, but are not limited to, a phenyl group, a naphthyl group, and a biphenyl group.

When the substituted or unsubstituted aryl group having 6 to 30 carbon atoms has a substituent (a substituted aryl group having 6 to 30 carbon atoms), the substituent is a halogen atom such as a fluorine atom, a chlorine atom, a bromine atom, or an iodine atom; an alkyl group having 1 to 10 carbon atoms such as a methyl group, an ethyl group, a propyl group, or an isopropyl group; an alkoxy group having 1 to 6 carbon atoms such as a methoxy group, an ethoxy group, or a propyloxy group; a hydroxy group; a cyano group; or a nitro group. The number of substituents may be one, or two or more. In addition, the substituted aryl group having 6 to 30 carbon atoms refers to a group in which the total number of carbon atoms of the substituent(s) and the aryl group is 6 to 30.

Among these, R² is preferably a substituted or unsubstituted alkyl group having 1 to 30 carbon atoms, more preferably a methyl group, an ethyl group, a propyl group, an isopropyl group, a hexyl group, an octyl group, a decyl group, a dodecyl group, a tetradecyl group, a hexadecyl group, an octadecyl group, a benzyl group, a hydroxymethyl group, or a 2-hydroxyethyl group, further preferably a methyl group, an ethyl group, a benzyl group, or a 2-hydroxyethyl group, particularly preferably a methyl group or a benzyl group, and most preferably a methyl group. In another embodiment, R² is preferably an alkyl group having 1 to 10 carbon atoms substituted with an aryl group having 6 to 20 carbon atoms, more preferably an alkyl group having 1 to 5 carbon atoms substituted with a phenyl group, further preferably a benzyl group or a phenylethyl group, and particularly preferably a benzyl group.

X is a halide ion (such as a fluoride ion, a chloride ion, a bromide ion, or an iodide ion), a hydroxide ion, an organic sulfonate ion (such as a methanesulfonate ion or a p-toluenesulfonate ion), a tetrafluoroborate anion, or a hexafluorophosphate anion. Among these, X is preferably a halide ion, and more preferably a chloride ion or a bromide ion.

Specific examples of the ammonium salt represented by the formula (1) in which R¹ is a substituted or unsubstituted alkyl group having 5 to 30 carbon atoms include: an ammonium salt having a hexyl group, such as hexyltrimethylammonium bromide; an ammonium salt having a heptyl group, such as heptyltrimethylammonium bromide; an ammonium salt having an octyl group, such as octyltrimethylammonium chloride and octyldimethylbenzylammonium chloride; an ammonium salt having a decyl group, such as decyltrimethylammonium chloride and decyldimethylbenzylammonium chloride; an ammonium salt having a dodecyl group, such as dodecyltrimethylammonium chloride, dodecyltrimethylammonium bromide, dodecylethyldimethylammonium chloride, dodecylethyldimethylammonium bromide, benzyldodecyldimethylammonium chloride, benzyldodecyldimethylammonium bromide, tridodecylmethylammonium chloride, and tridodecylmethylammonium bromide; an ammonium salt having a tetradecyl group, such as tetradecyltrimethylammonium bromide and benzyldimethyltetradecylammonium chloride; an ammonium salt having a hexadecyl group, such as hexadecyltrimethylammonium chloride, hexadecyltrimethylammonium bromide, hexadecyltrimethylammonium p-toluenesulfonate, hexadecyltrimethylammonium hydroxide, ethylhexadecyldimethylammonium chloride, ethylhexadecyldimethylammonium bromide, and benzyldimethylhexadecylammonium chloride; and an ammonium salt having an octadecyl group, such as trimethyloctadecylammonium chloride, trimethyloctadecylammonium bromide, dimethyldioctadecylammonium chloride, dimethyldioctadecylammonium bromide, and benzyldimethyloctadecylammonium chloride.

Specific examples of the ammonium salt represented by the formula (1) in which R¹ is a substituted or unsubstituted alkyl(poly)heteroalkylene group having 5 to 30 carbon atoms include trimethylpropyldi(oxyethylene)ammonium chloride and trimethylpropyl oxyethylene thioethylene ammonium chloride.

Specific examples of the ammonium salt represented by the formula (1) in which R¹ is a substituted or unsubstituted aryl(poly)heteroalkylene group having 7 to 30 carbon atoms include benzyl-dimethyl-2-{2-[4-(1,1,3,3-tetramethylbutyl)phenoxy]ethoxy}ethylammonium chloride (benzethonium chloride) and benzyldimethylphenyldi(oxyethylene)ammonium chloride.

### (Heteroaryl salt having a substituted or unsubstituted alkyl group having 5 to 30 carbon atoms)

Examples of heteroaryl salts having a substituted or unsubstituted alkyl group having 5 to 30 carbon atoms include, but are not limited to, salts of heteroaryl cations in which at least one nitrogen atom of a substituted or unsubstituted nitrogen atom-containing heteroaryl ring is bonded to a substituted or unsubstituted alkyl group having 5 to 30 carbon atoms.

Examples of the nitrogen atom-containing heteroaryl ring include, but are not limited to, imidazole, pyrazole, oxazole, isoxazole, thiazole, isothiazole, pyridine, pyrazine, pyridazine, pyrimidine, quinoline, and isoquinoline rings.

When the nitrogen atom-containing heteroaryl ring has a substituent, examples of substituents include a halogen atom such as a fluorine atom, a chlorine atom, a bromine atom, or an iodine atom; an alkyl group having 1 to 4 carbon atoms such as a methyl group, an ethyl group, a propyl group, or an isopropyl group; an aryl group having 6 to 20 carbon atoms such as a phenyl group or a naphthyl group; an alkoxy group having 1 to 6 carbon atoms such as a methoxy group, an ethoxy group, and a propyloxy group; a hydroxy group; a cyano group; and a nitro group.

Examples of alkyl groups having 5 to 30 carbon atoms include, but are not limited to, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an icosyl group, a docosyl group, a tetracosyl group, a hexacosyl group, an octacosyl group, and a triacontyl group.

When the substituted or unsubstituted alkyl group having 5 to 30 carbon atoms has a substituent (when the alkyl group is a substituted alkyl group having 5 to 30 carbon atoms), examples of substituents include a halogen atom such as a fluorine atom, a chlorine atom, a bromine atom, or an iodine atom; an alkyl group having 1 to 4 carbon atoms such as a methyl group, an ethyl group, a propyl group, or an isopropyl group; an aryl group having 6 to 20 carbon atoms such as a phenyl group or a naphthyl group; an alkoxy group having 1 to 6 carbon atoms such as a methoxy group, an ethoxy group, or a propyloxy group; a hydroxy group; a cyano group; and a nitro group. The number of substituents may be one, or two or more. In addition, the substituted alkyl group having 5 to 30 carbon atoms refers to a group in which the total number of carbon atoms of the substituent(s) and the alkyl group is 5 to 30.

Among these, the substituted or unsubstituted alkyl group having 5 to 30 carbon atoms is preferably a substituted or unsubstituted alkyl group having 8 to 20 carbon atoms, more preferably an alkyl group having 10 to 20 carbon atoms, further preferably a decyl group, a dodecyl group, a tetradecyl group, a hexadecyl group, or an octadecyl group.

Examples of counter anions of the heteroaryl cation having a substituted or unsubstituted alkyl group having 5 to 30 carbon atoms include, but are not limited to, halide ions such as a fluoride ion, a chloride ion, a bromide ion, and an iodide ion; a hydroxide ion; organic sulfonate ions such as a methanesulfonate ion and a p-toluenesulfonate ion; a tetrafluoroborate anion; and a hexafluorophosphate anion. Among these, the counter anion is preferably a halide ion, and more preferably a chloride ion or a bromide ion.

Specific examples of heteroaryl salts having a substituted or unsubstituted alkyl group having 5 to 30 carbon atoms include: imidazolium salts such as 1-methyl-3-hexylimidazolium chloride, 1-octyl-3-methylimidazolium chloride, 1-octyl-3-methylimidazolium bromide, 1-octyl-3-methylimidazolium tetrafluoroborate, 1-decyl-3-methylimidazolium chloride, 1-decyl-3-methylimidazolium bromide, 1-decyl-3-methylimidazolium tetrafluoroborate, 1-dodecyl-3-methylimidazolium chloride, 1-dodecyl-3-methylimidazolium bromide, 1-tetradecyl-3-methylimidazolium chloride, 1-tetradecyl-3-methylimidazolium bromide, 1-hexadecyl-3-methylimidazolium chloride, 1-hexadecyl-3-methylimidazolium bromide, 1-octadecyl-3-methylimidazolium chloride, and 1-octadecyl-3-methylimidazolium bromide; oxazolium salts such as 3-decyloxazolium chloride, 3-dodecyloxazolium chloride, 3-tetradecyloxazolium chloride, 3-hexadecyloxazolium chloride, and 3-octadecyloxazolium chloride; thiazolium salts such as 3-decylthiazolium chloride, 3-dodecylthiazolium chloride, 3-tetradecylthiazolium chloride, 3-hexadecylthiazolium chloride, and 3-octadecylthiazolium chloride; pyridinium salts such as 1-decylpyridinium bromide, 1-dodecylpyridinium bromide, 1-dodecylpyridinium chloride, 1-tetradecylpyridinium chloride, 1-tetradecylpyridinium bromide, 1-hexadecylpyridinium chloride, 1-hexadecylpyridinium bromide, 1-hexadecylpyridinium chloride, 1-octadecylpyridinium chloride, and 1-octadecylpyridinium bromide; pyrimidinium salts such as 1-decylpyrimidinium chloride, 1-dodecylpyrimidinium chloride, 1-tetradecylpyrimidinium chloride, 1-hexadecylpyrimidinium chloride, and 1-octadecylpyrimidinium chloride; quinolinium salts such as decylquinolinium chloride, dodecylquinolinium chloride, tetradecylquinolinium chloride, hexadecylquinolinium chloride, and octadecylquinolinium chloride; and isoquinolinium salts such as decylisoquinolinium chloride, dodecylisoquinolinium chloride, tetradecylisoquinolinium chloride, hexadecylisoquinolinium chloride, and octadecylisoquinolinium chloride. These may also be used in the form of hydrates.

### (Substituted or unsubstituted thiol having 5 to 30 carbon atoms)

Examples of substituted or unsubstituted thiols having 5 to 30 carbon atoms include, but are not limited to, 1-pentanethiol, 2-pentanethiol, 3-pentanethiol, 1-hexanethiol, 1-heptanethiol, 1-octanethiol, 1-nonanethiol, 1-decanethiol, 1-undecanethiol, 1-dodecanethiol, 1-tetradecanethiol, 1-hexadecanethiol, and 1-octadecanethiol.

When the substituted or unsubstituted thiol having 5 to 30 carbon atoms has a substituent (when the thiol is a substituted thiol having 5 to 30 carbon atoms), examples of substituents include a halogen atom such as a fluorine atom, a chlorine atom, a bromine atom, or an iodine atom; an aryl group having 6 to 20 carbon atoms such as a phenyl group or a naphthyl group; an alkoxy group having 1 to 6 carbon atoms such as a methoxy group, an ethoxy group, or a propyloxy group; a hydroxy group; a cyano group; and a nitro group. The number of substituents may be one, or two or more. In addition, the substituted thiol having 5 to 30 carbon atoms refers to a group in which the total number of carbon atoms of the substituent(s) and thiol is 5 to 30.

The aforementioned copper surface protective agent may be used alone or in combination of two or more.

In one embodiment, the copper surface protective agent preferably includes a heteroaryl salt having a substituted or unsubstituted alkyl group having 5 to 30 carbon atoms, more preferably a heteroaryl salt having a substituted or unsubstituted alkyl group having 8 to 30 carbon atoms, further preferably at least one selected from the group consisting of a pyridinium salt having a substituted or unsubstituted alkyl group having 8 to 30 carbon atoms and an imidazolium salt having a substituted or unsubstituted alkyl group having 8 to 30 carbon atoms, and particularly preferably at least one selected from the group consisting of a pyridinium salt having a substituted or unsubstituted alkyl group having 14 to 20 carbon atoms and an imidazolium salt having a substituted or unsubstituted alkyl group having 8 to 14 carbon atoms, from the viewpoint of suppressing oxidation of copper wiring more effectively.

That is, in a preferred embodiment, the copper surface protective agent preferably includes a pyridinium salt having a substituted or unsubstituted alkyl group having 14 to 20 carbon atoms, more preferably a pyridinium salt having an alkyl group having 14 to 18 carbon atoms and a pyridinium salt having an alkyl group having 18 to 20 carbon atoms, further preferably a pyridinium salt having an alkyl group having 14 to 16 carbon atoms and a pyridinium salt having an alkyl group having 16 to 18 carbon atoms, and particularly preferably a pyridinium salt having an alkyl group having 16 to 18 carbon atoms.

In another preferred embodiment, the copper surface protective agent preferably includes an imidazolium salt having a substituted or unsubstituted alkyl group having 8 to 14 carbon atoms, more preferably an imidazolium salt having an alkyl group having 10 to 14 carbon atoms, and further preferably an imidazolium salt having an alkyl group having 12 to 14 carbon atoms.

In one embodiment, the copper surface protective agent preferably includes a substituted or unsubstituted thiol having 5 to 30 carbon atoms, more preferably a substituted or unsubstituted thiol having 8 to 20 carbon atoms, further preferably a thiol having 8 to 16 carbon atoms, particularly preferably a thiol having 10 to 16 carbon atoms, and most preferably a thiol having 10 to 14 carbon atoms.

The content of the copper surface protective agent is preferably 0.0001 to 5% by mass, more preferably 0.001 to 1% by mass, further preferably 0.01 to 1% by mass, particularly preferably 0.07 to 0.5% by mass, and most preferably 0.07 to 0.3% by mass based on the total mass of the composition from the viewpoint of suppressing oxidation of copper wiring more effectively.

### [Organic solvent]

The composition according to the present invention preferably contains an organic solvent.

The organic solvent functions to promote the removal of resist. For example, because of its lipophilicity, the organic solvent allows both the basic compound and water to penetrate into the resist, and reduces adhesion between the substrate and the resin, thereby enabling effective removal of the resist.

Examples of organic solvents include, but are not limited to, monohydric alcohols such as methanol, ethanol, 1-propanol, 2-propanol, 1-butanol, tert-butanol, 1-pentanol, 1-hexanol, 1-heptanol, 1-octanol, 1-nonanol, and 1-decanol; diols such as ethylene glycol, propylene glycol, neopentyl glycol, 1,2-hexanediol, 1,6-hexanediol, and 2-ethylhexane-1,3-diol; polyhydric alcohols such as glycerol; ethers such as dimethyl ether, diethyl ether, tetrahydrofuran, and 1,4-dioxane; glycol ethers such as ethylene glycol monomethyl ether, ethylene glycol monoethyl ether, ethylene glycol monobutyl ether, ethylene glycol n-butyl ether (2-butoxyethanol), ethylene glycol monophenyl ether (phenyl glycol), propylene glycol monomethyl ether, propylene glycol monoethyl ether, propylene glycol n-propyl ether, propylene glycol n-butyl ether, propylene glycol phenyl ether, diethylene glycol monomethyl ether, diethylene glycol monoethyl ether, diethylene glycol monobutyl ether, diethylene glycol monophenyl ether, dipropylene glycol monomethyl ether, dipropylene glycol monoethyl ether, dipropylene glycol n-propyl ether, dipropylene glycol n-butyl ether, tripropylene glycol monomethyl ether, tripropylene glycol n-propyl ether, tripropylene glycol n-butyl ether, and dipropylene glycol dimethyl ether; amides such as dimethylformamide, diethylformamide, dimethylacetamide, and N-methylpyrrolidone; and heterocycles such as pyrrole, pyridine, and triazole. Among these, the organic solvent preferably includes glycol ether, and more preferably at least one selected from the group consisting of ethylene glycol monoethyl ether, 2-butoxyethanol, phenyl glycol, propylene glycol monoethyl ether, diethylene glycol monoethyl ether, diethylene glycol monobutyl ether, and diethylene glycol monophenyl ether. The aforementioned organic solvents may be used alone or in combination of two or more.

The content of the organic solvent is preferably 0.01 to 20% by mass, more preferably 0.1 to 10% by mass, and further preferably 1 to 10% by mass based on the total mass of the composition.

### [Water]

Water may function to promote the removal of resist. For example, by combining water with a basic compound, basic soluble resin is dissolved, which modifies the resist structure and reduces adhesion between the substrate and the resin, thereby enabling effective removal of the resist from the substrate.

The content of water is preferably 60 to 99% by mass, and more preferably 60 to 80% by mass, 70 to 99% by mass, 80 to 99% by mass, and 90 to 99% by mass based on the total mass of the composition.

### [Physical properties of the composition]

The pH of the composition according to the present invention is 13 or higher, preferably 13 to 14.5, and more preferably 13 to 14. By setting the pH to 13 or higher, the resist can be removed and oxidation of copper wiring can be suppressed.

### 2. Method for manufacturing electronic substrate

In one embodiment, the present invention provides a method for manufacturing an electronic substrate. The method for manufacturing an electronic substrate comprises a step of bringing the aforementioned composition into contact with a substrate comprising copper wiring and a resist disposed between the copper wirings, thereby removing the resist, and forming a protective layer on the surface of the copper wiring.

### [Substrate]

The substrate has copper wiring and a resist disposed between the copper wirings.

Examples of substrates include, but are not limited to, resin substrates (substrates obtained by impregnating paper or glass with resin such as phenol resin, epoxy resin, fluororesin, and bismaleimide-triazine resin; specifically, phenolic paper substrates, epoxy paper substrates, Teflon substrates, and glass epoxy substrates), silicon substrates, silicon carbide substrates, sapphire substrates, gallium phosphide (GaP) substrates, gallium arsenide (GaAs) substrates, indium phosphide (InP) substrates, gallium nitride (GaN) substrates, and glass substrates. Among these, resin substrates and silicon substrates are preferred.

In one embodiment, the substrate is a single-layer substrate of a resin substrate.

In another embodiment, the substrate may have a laminated structure with a seed layer (conductive layer). In one embodiment, the substrate is a laminated substrate of a resin substrate and a seed layer. The seed layer may be a copper plating layer or a sputtered copper layer used in a semi-additive process (SAP), or a copper foil layer used in a modified semi-additive process (MSAP).

In another embodiment, the substrate may have a patterned metal circuit. In one embodiment, the substrate is a circuit substrate having a resin substrate and a metal circuit. The metal constituting the metal circuit is not particularly limited, but is preferably copper, aluminum, cobalt, or a combination thereof, and more preferably copper.

The substrate has copper wiring and a resist disposed between the wirings.

For example, when the substrate is a single-layer substrate of a resin substrate, a silicon substrate, or the like, copper wiring (circuit) and a resist are formed on the surface of the single-layer substrate (resin substrate, silicon substrate or the like).

When the substrate is a laminated substrate of a resin substrate and a seed layer, copper wiring (circuit) and a resist are formed on the surface of the seed layer.

Furthermore, when the substrate is a circuit substrate having a resin substrate and a metal circuit, copper wiring (connection terminals such as pillars and bumps) is formed on the metal circuit, and a resist is formed on the resin substrate.

The pattern that can be formed on the substrate is usually formed based on a pattern design created according to applications and desired performance.

For example, when the substrate is a single-layer substrate or a laminated substrate, the pattern that can be formed on the substrate may be a circuit. Examples of such circuit patterns include a comb pattern (also referred to as a "line and space pattern," in which metal wiring is formed in parallel lines).

When the substrate is a circuit substrate, the pattern formed on the substrate may be a pattern of connection terminals such as pillars and bumps. Examples of such connection terminal patterns include a dot pattern (also referred to as a "pillar pattern," in which metal wiring is formed in the form of dots).

A known method of patterning is appropriately employed.

### (Copper wiring)

The copper wiring is wiring mainly composed of copper. The copper wiring may further include copper oxide or inevitable impurities. The shape of the copper wiring is not particularly limited.

The copper wiring width is preferably 50 µm or less, more preferably 30 µm or less, further preferably 20 µm or less, and particularly preferably less than 15 µm. The lower limit of the copper wiring width is not particularly limited, but is preferably 1 µm or more, more preferably 3 µm or more, and further preferably 5 µm or more. A copper wiring width of 50 µm or less is preferred, because a miniaturized electronic substrate can be manufactured. In the present description, the "copper wiring width" means the minimum width of copper wiring when the copper wiring is formed linearly in a pattern such as a comb pattern. The copper wiring width is the average value of any 30 copper wiring widths. The copper wiring width is also referred to as a line.

The dot diameter of the copper wiring is not particularly limited, but is preferably 800 µm or less, more preferably 10 to 600 µm, further preferably 50 to 500 µm, and particularly preferably 100 to 300 µm. A dot diameter of the copper wiring of 800 µm or less is preferred, because a miniaturized electronic substrate can be manufactured. In the present description, the "dot diameter of the copper wiring" means the diameter of the top surface (the surface opposite the substrate contact surface) when the copper wiring is formed into a cylindrical shape in a pattern such as a dot pattern. The "diameter" means the maximum distance between two points on the circular outer edge. The dot diameter of the copper wiring is the average value of any 30 dot diameters of the copper wiring.

The thickness of the copper wiring is not particularly limited, but is preferably 1 µm or more, more preferably 5 to 50 µm, and further preferably 10 to 30 µm. A thickness of the copper wiring of 1 µm or more is preferred, because the electrical resistance of the printed wiring board can be reduced. In the present description, the "thickness of the copper wiring" means the maximum distance between the substrate contact surface of the copper wiring and the top surface (the surface opposite the substrate contact surface) of the copper wiring. The thickness of the copper wiring is the average value of any 30 thicknesses of the copper wiring.

### (Resist disposed between metal wirings)

The resist may be, for example, a dry film resist or a liquid resist. Among these, the resist is preferably a dry film resist.

The dry film resist is not particularly limited, but is preferably formed from a photosensitive resin. Examples of the photosensitive resin include negative photosensitive resins and positive photosensitive resins.

The negative photosensitive resin is not particularly limited, but examples include azide-based photosensitive resins, diazo-based photosensitive resins, low molecular weight acetylenic photosensitive resins, low-molecular weight ethylenic photosensitive resins, insoluble polymer-based photosensitive resins, and chromic acid-based photosensitive resins. These negative photosensitive resins may be used alone or in combination of two or more.

The positive photosensitive resin is not particularly limited, but examples include quinone diazide-based photosensitive resins and soluble polymer-based photosensitive resins. These positive photosensitive resins may be used alone or in combination of two or more.

Among these, the dry film resist is preferably formed from a negative photosensitive resin.

The resist width is preferably 50 µm or less, more preferably 30 µm or less, further preferably 20 µm or less, and particularly preferably 15 µm or less. The lower limit of the resist width is not particularly limited, but is preferably 1 µm or more, more preferably 3 µm or more, and further preferably 5 µm or more. A resist width of 50 µm or less is preferred because a miniaturized electronic substrate can be manufactured. In the present description, the "resist width" means the minimum width of resist when the resist is formed linearly in a pattern such as a comb pattern. The resist width is the average value of any 30 resist widths.

The copper wiring width/resist width of the substrate is preferably 50 µm or less/50 µm or less, more preferably 30 µm or less/30 µm or less, further preferably 20 µm or less/20 µm or less, and particularly preferably 3 to 15 µm/3 to 15 µm. A copper wiring width/resist width of the substrate of 50 µm or less/50 µm or less is preferred, because a miniaturized electronic substrate can be manufactured.

### (Contact)

In the resist removing step, the above-described substrate is brought into contact with the composition according to the present invention to remove the resist and form a protective layer on the copper wiring surface. Thus, the resist can be removed, and an electronic substrate patterned with copper wiring can be obtained. In addition, since a protective layer is formed on the copper wiring surface, the substrate can be stored for a long period of time even after resist removal.

The contacting method is not particularly limited, and known techniques may be appropriately employed. Specifically, the substrate may be immersed into the composition according to the present invention, or the composition according to the present invention may be sprayed onto the substrate, or dropped onto the substrate (e.g., a single-wafer spin process). The immersion may be repeated two or more times, the spraying may be repeated two or more times, the dropping may be repeated two or more times, or immersion, spraying, and dropping may be combined.

The contact temperature is not particularly limited, but is preferably 0 to 90°C, more preferably 15 to 70°C, and further preferably 20 to 60°C.

The contact time is not particularly limited, but is preferably 1 second to 30 minutes, more preferably 30 seconds to 20 minutes, further preferably 1 to 20 minutes, and particularly preferably 2 to 20 minutes. A contact time of 1 second or more is preferred, because the resist can be removed at a high stripping ratio. On the other hand, a contact time of 30 minutes or less is preferred, because the production cost can be reduced.

The resist lifting time in the resist removing step is preferably within 10 minutes, more preferably within 7 minutes, further preferably within 5 minutes, particularly preferably within 3 minutes, and most preferably within 50 seconds. In the present description, the "lifting time" means the time from immersion of the substrate in the composition according to the present invention until completion of stripping.

The protective layer formed on the surface of the copper wiring is preferably removed after storage. For example, the protective layer can be removed by cleaning the surface of the electronic substrate with an acidic aqueous solution, a basic aqueous solution, or warm water (40 to 80°C, preferably 40 to 60°C), or by heating the electronic substrate by annealing or the like (90 to 150°C, preferably 100 to 140°C).

In addition, when the electronic substrate is a laminated substrate composed of, for example, a resin substrate and a seed layer, the protective layer can be removed simultaneously by performing flash etching of the seed layer after resist removal.

### [Electronic substrate]

The electronic substrate comprises a substrate and metal wiring disposed on the substrate.

In this case, the shape of the metal wiring may reflect the shape of the metal wiring formed on the substrate before the pretreatment step.

The type of the substrate and the metal wiring, the metal wiring width (line), the dot diameter of the metal wiring, and the thickness of the metal wiring are as described above.

The surface of the electronic substrate may be exposed when the resist is removed. For example, in a comb pattern (line-and-space pattern), the exposed portion of the substrate (resist-removed portion) is referred to as a space.

The space width may reflect the resist width. That is, the space width is preferably 50 µm or less, more preferably 30 µm or less, further preferably 20 µm or less, and particularly preferably less than 15 µm. The lower limit of the space width is not particularly limited, but is preferably 1 µm or more, more preferably 3 µm or more, and further preferably 5 µm or more. In the present description, the "space width" means the minimum width of the space when the space is formed linearly in a pattern such as a comb pattern. The space width is the average value of any 30 space widths.

The line/space of the electronic substrate is preferably 50 µm or less / 50 µm or less, more preferably 30 µm or less / 30 µm or less, further preferably 20 µm or less / 20 µm or less, and particularly preferably 3 to 15 µm / 3 to 15 µm. A line/space of the electronic substrate of 50 µm or less / 50 µm or less is preferred, because miniaturization and higher functionality of electronic devices can be achieved.

### 3. Method for removing resist

In one embodiment, the present invention provides a method for removing resist. The method for removing resist comprises a step of bringing the aforementioned composition into contact with a substrate comprising copper wiring and a resist disposed between the copper wirings, thereby removing the resist, and forming a protective layer on the surface of the copper wiring.

The aforementioned removal method can remove resist. In addition, since the copper surface protective agent protects the copper wiring, the aforementioned removal method can suppress oxidation of the copper wiring.

The resist removing step and the like are as described above.

### 4. Kit

In one embodiment, the present invention provides a kit. The kit is used for the method for manufacturing an electronic substrate or the method for removing resist described above. The kit comprises a first solution comprising a basic compound and a second solution comprising a copper surface protective agent, and the first and second solutions are kept in an unmixed state and mixed at the time of use.

### [First solution]

The first solution comprises a basic compound, preferably a strongly basic compound. Water, an organic solvent, or the like may also be included if necessary.

The basic compound, water, and organic solvent described above are used.

In a preferred embodiment, the first solution comprises a strongly basic compound and water.

### [Second solution]

The second solution comprises a copper surface protective agent. A weakly basic compound, water, an organic solvent, or the like may also be included if necessary.

The copper surface protective agent, the weakly basic compound, water, and organic solvent described above are used.

In a preferred embodiment, the second solution comprises a copper surface protective agent (preferably a heteroaryl salt having a substituted or unsubstituted alkyl group having 5 to 30 carbon atoms, more preferably an imidazolium salt having a substituted or unsubstituted alkyl group having 5 to 30 carbon atoms) and water.

In another preferred embodiment, the second solution comprises a copper surface protective agent (preferably a heteroaryl salt having a substituted or unsubstituted alkyl group having 5 to 30 carbon atoms, more preferably an imidazolium salt having a substituted or unsubstituted alkyl group having 5 to 30 carbon atoms), a weakly basic compound, and water.

In another preferred embodiment, the second solution comprises a copper surface protective agent (preferably a heteroaryl salt having a substituted or unsubstituted alkyl group having 5 to 30 carbon atoms, more preferably an imidazolium salt having a substituted or unsubstituted alkyl group having 5 to 30 carbon atoms), an organic solvent, and water.

In another preferred embodiment, the second solution comprises a copper surface protective agent (preferably a heteroaryl salt having a substituted or unsubstituted alkyl group having 5 to 30 carbon atoms, more preferably an imidazolium salt having a substituted or unsubstituted alkyl group having 5 to 30 carbon atoms), a weakly basic compound, an organic solvent, and water.

When the copper surface protective agent is a heteroaryl salt having a substituted or unsubstituted alkyl group having 5 to 30 carbon atoms (preferably an imidazolium salt having a substituted or unsubstituted alkyl group having 5 to 30 carbon atoms), by keeping the second solution comprising the heteroaryl salt and the first solution comprising a strongly basic compound in an unmixed state, decomposition reactions of the heteroaryl salt (such as nucleophilic substitution reaction, β-elimination reaction, and hydrolysis reaction) can be prevented.

At the time of use, the first solution and the second solution are mixed to prepare a composition, and the kit can be used for the method for manufacturing an electronic substrate or the method for removing resist described above. At this time, in order to adjust the formulation of the final composition, at least one selected from the group consisting of a basic compound, a copper surface protective agent, water, and an organic solvent, preferably water, may be further added together with the first solution and the second solution.

### Examples

Hereinafter, the present invention will be described in detail with reference to Examples, but the present invention is not limited thereto.

### [Example 1]

A composition was prepared by mixing 2 parts by mass of tetramethylammonium hydroxide (TMAH), which is a basic compound (a strongly basic compound), 0.05 parts by mass of 1-hexadecylpyridinium chloride monohydrate (1-HexDPC), which is a copper surface protective agent, and 97.95 parts by mass of water.

The pH of the prepared composition was measured and found to be 13.5. The pH was measured at 20°C using a benchtop pH meter (F-71, manufactured by HORIBA, Ltd.) and a pH electrode (9615S-10D, manufactured by HORIBA, Ltd.).

### [Examples 2 to 15 and Comparative Examples 1 to 6]

The compositions were prepared in the same manner as in Example 1 except that the formulation was changed to those described in Table 1.

**[Table 1]**

| | Basic compound | | | | Copper surface protective agent | | Organic solvent | | Water | pH |
|---|---|---|---|---|---|---|---|---|---|---|
| | Strongly basic compound | | Weakly basic compound | | | | | | | |
| | Type | Content (% by mass) | Type^{*1} | Content (% by mass) | Type^{*2} | Content (% by mass) | Type^{*3} | Content (% by mass) | Content (% by mass) | |
| Example 1 | TMAH | 2 | - | 0 | HexDPC | 0.05 | - | 0 | 97.95 | 13.5 |
| Example 2 | KOH | 5 | - | 0 | HexDPC | 0.05 | - | 0 | 94.95 | 14.0 |
| Example 3 | TMAH | 2 | - | 0 | HexDPC | 0.01 | - | 0 | 97.99 | 13.4 |
| Example 4 | TMAH | 2 | - | 0 | HexDPC | 0.1 | - | 0 | 97.9 | 13.4 |
| Example 5 | TMAH | 5 | - | 0 | HexDPC | 0.05 | - | 0 | 94.95 | 13.9 |
| Example 6 | TMAH | 2 | - | 0 | DDThiol | 0.05 | - | 0 | 97.95 | 13.4 |
| Example 7 | TMAH | 2 | - | 0 | BzDMHexDAC | 0.1 | - | 0 | 97.9 | 13.4 |
| Example 8 | TMAH | 2 | - | 0 | DDPC | 0.1 | - | 0 | 97.9 | 13.4 |
| Example 9 | TMAH | 2 | - | 0 | DMIC | 0.1 | - | 0 | 97.9 | 13.4 |
| Example 10 | TMAH | 2 | - | 0 | DDMIC | 0.1 | - | 0 | 97.9 | 13.4 |
| Example 11 | TMAH | 2 | - | 0 | HexDMIC | 0.1 | - | 0 | 97.9 | 13.4 |
| Example 12 | TMAH | 2 | - | 0 | MOctDIC | 0.1 | - | 0 | 97.9 | 13.4 |
| Example 13 | TMAH | 2 | - | 0 | TMOctDAC | 0.1 | - | 0 | 97.9 | 13.4 |
| Example 14 | TMAH | 2 | MEA | 20 | HexDPC | 0.05 | - | 0 | 77.95 | 13.7 |
| Example 15 | TMAH | 2 | MEA | 20 | HexDPC | 0.05 | PheGly | 3 | 74.95 | 13.7 |
| Comparative Example 1 | TMAH | 2 | - | 0 | - | 0 | - | 0 | 98 | 13.4 |
| Comparative Example 2 | KOH | 5 | - | 0 | - | 0 | - | 0 | 95 | 14.0 |
| Comparative Example 3 | - | 0 | MEA | 5 | HexDPC | 0.05 | - | 0 | 94.95 | 12.0 |
| Comparative Example 4 | - | 0 | MEA | 20 | HexDPC | 0.05 | - | 0 | 79.95 | 12.3 |
| Comparative Example 5 | TMAH | 2 | - | 0 | DDPhos | 0.1 | - | 0 | 97.9 | 13.4 |
| Comparative Example 6 | TMAH | 2 | - | 0 | OctPhos | 0.1 | - | 0 | 97.9 | 13.4 |

| | | | | | | | | | | |
|---|---|---|---|---|---|---|---|---|---|---|
| *1 MEA: monoethanolamine *2 HexDPC: 1-hexadecylpyridinium chloride monohydrate, DDThiol: 1-dodecanethiol, BzDMHexDAC: benzyl dimethyl hexadecylammonium chloride, DDPC: 1-dodecylpyridinium chloride, DMIC: 1-decyl-3-methylimidazolium chloride, DDMIC: 1-dodecyl-3-methyl-1H-imidazol-3-ium chloride, HexDMIC: 1-hexadecyl-3-methylimidazolium chloride monohydrate, MOctDIC: 3-methyl-1-octadecylimidazolium chloride, TMOctDAC: trimethyl octadecylammonium chloride, DDPhos: dodecylphosphonic acid, OctPhos: octylphosphonic acid, *3 PheGly: phenyl glycol | | | | | | | | | | |

The structural formulae of the copper surface protective agents and the like used in Examples and Comparative Examples are shown below.

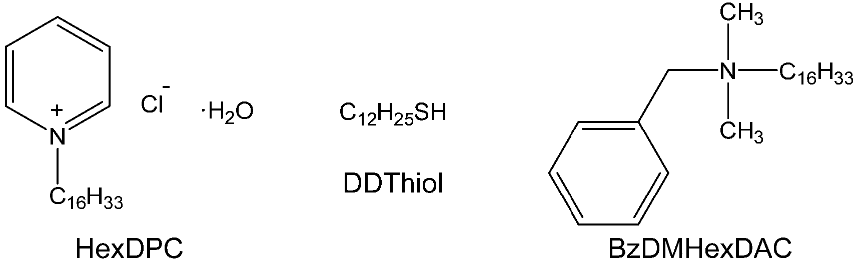

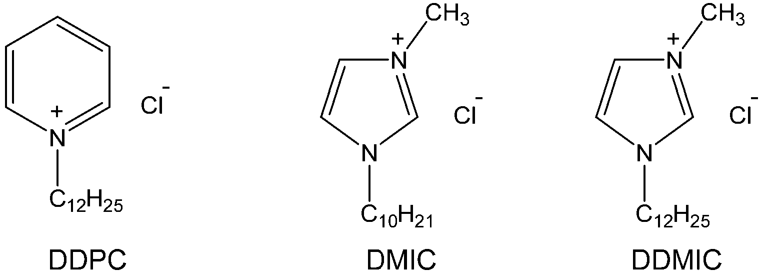

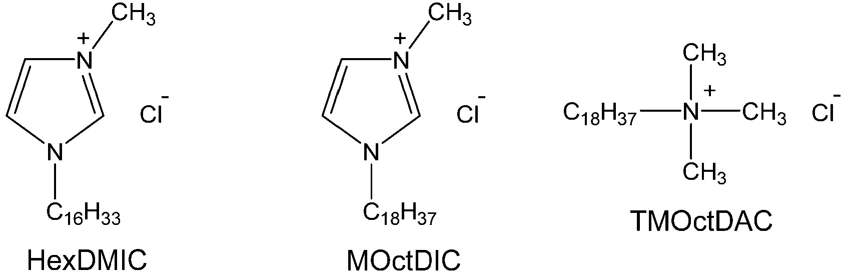

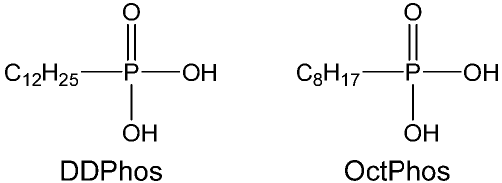

### [Evaluation]

The compositions prepared in Examples 1 to 15 and Comparative Examples 1 to 6 were evaluated.

### (Copper oxidation ratio)

### (1) Pretreatment

An electrolytic copper plating substrate (copper film thickness: 15,000 Å) was cut into 2 cm × 2 cm pieces, immersed into a mixed solution of 1% hydrogen peroxide (H₂O₂)/1% sulfuric acid (H₂SO₄)/98% water at room temperature (23°C) for 20 seconds, rinsed with water, and dried. Then, the dried substrate was immersed into a 1% aqueous sulfuric acid (H₂SO₄) solution at room temperature (23°C) for 5 minutes, rinsed with water, and dried. X-ray photoelectron spectroscopy (XPS; PHI Quantera II manufactured by ULVAC-PHI, Inc.) analysis of the surface of the electrolytic copper plating substrate immediately after treatment confirmed that copper oxide (CuO) was not present on the surface of the electrolytic copper plating substrate.

### (2) Formation of copper surface protective layer

The electrolytic copper plating substrate after copper oxide (CuO) removal was immersed into the composition at 50°C under stirring. Then, the substrate was rinsed with water at 23°C for 10 seconds, and water was removed from the surface by nitrogen blow-drying, thereby forming a copper surface protective layer on the copper layer of the electrolytic copper plating substrate.

The immersion time of the electrolytic copper plating substrate in the composition under stirring was the same as the immersion time of the substrate in the composition under stirring in the evaluation of the strippability of the dry film resist described later (the process time in Table 2).

### (3) Evaluation of Copper oxidation ratio

The electrolytic copper plating substrate on which a copper surface protective layer was formed was stored in air at 20°C for 24 hours.

The copper oxidation ratio of the electrolytic copper plating substrate having the copper surface protective layer after storage was measured.

Specifically, the electrolytic copper plating substrate having the copper surface protective layer after storage was analyzed by X-ray photoelectron spectroscopy (XPS; PHI Quantera II, manufactured by ULVAC-PHI, Inc.), and a narrow scan spectrum of Cu2p was obtained. The resulting Cu2p narrow scan spectrum was analyzed by curve fitting to calculate the peak areas derived from copper(II) oxide (CuO) and copper(II) hydroxide (Cu(OH)₂) each within Cu²⁺, as well as the sum of the peak areas of Cu⁺ and Cu. Using the resulting peak areas, the copper oxidation ratio (obtained by dividing the peak area of copper(II) oxide (CuO) within Cu²⁺ by the sum of the peak areas of Cu⁺ and Cu) was determined. A higher copper oxidation ratio, i.e., a greater amount of Cu²⁺ (the copper(II) oxide (CuO) component) than Cu⁺ and Cu, indicates that the surface of the plated Cu layer of the Cu sample was more oxidized during storage of the electrolytic copper plating substrate. The results obtained are shown in Table 2 below. Table 2 also shows the results of Reference Example in which "(2) Formation of copper surface protective layer" was not performed (no composition was used).

### (Lifting time (L.T.) and strippability of dry film resist)

### (1) Preparation of substrate

A negative-type dry film resist RD-1225 (manufactured by Showa Denko Materials Co., Ltd., thickness: 25 µm) was laminated on a substrate, which is a copper-clad laminate (CCL-HL832NS (MT-FL), manufactured by Mitsubishi Gas Chemical Co., Inc.), and the exposed region was cured by exposure. Next, the unexposed region was removed with a developer (1 wt% aqueous sodium carbonate solution) to obtain a substrate on which a resist pattern was formed. The formed resist pattern was a comb pattern (exposed in parallel lines) with a line/space of 20 µm/20 µm. Next, copper plating was performed on the substrate exposed by development to form copper wiring having a thickness of 10 µm. Thus, a substrate having copper wiring (thickness: 10 µm) and resist (thickness: 25 µm) disposed between copper wirings was produced.

### (2) Evaluation of lifting time (L.T.)

The substrate was cut into 2 cm × 2 cm pieces and immersed into the composition at 50°C under stirring. The time from the start of immersion to completion of stripping was measured as the lifting time. The "completion of stripping" means that the entire surface of the resist in contact with the substrate is separated from the substrate. Completion of stripping is determined by visual inspection.

### (3) Evaluation of strippability

After the substrate was immersed into the composition under stirring until the immersion time reached a predetermined time, the substrate was washed with water and dried to produce an electronic substrate.

Strippability was evaluated using an optical microscope MX-63L (manufactured by Olympus Corporation) according to the following criteria.
A: The resist was successfully stripped, and no stripping residue remained.
B: Some stripping residue remained, but the resist was mostly stripped.
C: A large amount of stripping residue remained, or the resist could not be stripped.

**[Table 2]**

| | Copper oxidation ratio | Dry film resist | | |
|---|---|---|---|---|
| | | L.T. (s) | Process time (s) | Strippability |
| Example 1 | 2.6 | 300 | 600 | B |
| Example 2 | 0.5 | 46 | 150 | B |
| Example 3 | 2 | 390 | 600 | B |
| Example 4 | 0.8 | 360 | 600 | B |
| Example 5 | 1.3 | 90 | 300 | B |
| Example 6 | 2.9 | 300 | 600 | B |
| Example 7 | 6.5 | 360 | 720 | B |
| Example 8 | 6.7 | ND | 900 | B |
| Example 9 | 4.8 | ND | 900 | B |
| Example 10 | 3 | ND | 900 | B |
| Example 11 | 7 | 390 | 780 | B |
| Example 12 | 5.1 | 330 | 660 | B |
| Example 13 | 5.9 | 360 | 720 | B |
| Example 14 | 1 | 52 | 104 | A |
| Example 15 | 3 | 40 | 300 | A |
| Comparative Example 1 | 10.5 | 360 | 600 | B |
| Comparative Example 2 | 10.1 | 60 | 150 | C |
| Comparative Example 3 | 9 | 82 | 300 | A |
| Comparative Example 4 | 9.7 | 103 | 206 | B |
| Comparative Example 5 | 10.6 | 360 | 720 | B |
| Comparative Example 6 | 11 | 360 | 720 | B |
| Reference Example | 11.3 | - | - | - |

| | | | | |
|---|---|---|---|---|
| *ND:No data | | | | |

The results in Table 2 show that the compositions of Examples 1 to 15 effectively suppressed oxidation of the copper surface by protecting the copper surface, and also enabled effective removal of the resist.

## Claims

1. A composition comprising:
a basic compound; and
a copper surface protective agent comprising at least one selected from the group consisting of an ammonium salt represented by the following formula (1): 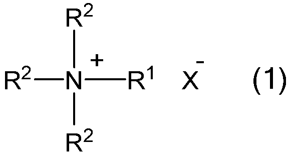
(wherein R¹ is a substituted or unsubstituted alkyl group having 5 to 30 carbon atoms, a substituted or unsubstituted alkyl(poly)heteroalkylene group having 5 to 30 carbon atoms, or a substituted or unsubstituted aryl(poly)heteroalkylene group having 7 to 30 carbon atoms;
R² is each independently a substituted or unsubstituted alkyl group having 1 to 30 carbon atoms, or a substituted or unsubstituted aryl group having 6 to 30 carbon atoms; and
X is a halide ion, a hydroxide ion, an organic sulfonate ion, a tetrafluoroborate anion, or a hexafluorophosphate anion),
a heteroaryl salt having a substituted or unsubstituted alkyl group having 5 to 30 carbon atoms, and a substituted or unsubstituted thiol having 5 to 30 carbon atoms,
wherein the composition has a pH of 13 or higher.

2. The composition according to claim 1, wherein the basic compound comprises a strongly basic compound.

3. The composition according to claim 2, wherein the strongly basic compound comprises an inorganic strongly basic compound.

4. The composition according to claim 2, wherein the content of the strongly basic compound is 3 to 10% by mass based on the total mass of the composition.

5. The composition according to claim 2, wherein the basic compound further comprises a weakly basic compound.

6. The composition according to claim 1, wherein the copper surface protective agent comprises a heteroaryl salt having a substituted or unsubstituted alkyl group having 8 to 20 carbon atoms.

7. The composition according to claim 6, wherein the copper surface protective agent comprises a pyridinium salt having a substituted or unsubstituted alkyl group having 14 to 20 carbon atoms.

8. The composition according to claim 6, wherein the copper surface protective agent comprises an imidazolium salt having a substituted or unsubstituted alkyl group having 8 to 14 carbon atoms.

9. The composition according to claim 1, wherein the copper surface protective agent comprises a substituted or unsubstituted thiol having 8 to 20 carbon atoms.

10. The composition according to claim 1, wherein the content of the copper surface protective agent is 0.07 to 0.5% by mass based on the total mass of the composition.

11. The composition according to claim 1, further comprising an organic solvent.

12. A method for manufacturing an electronic substrate, comprising a step of bringing the composition according to any one of claims 1 to 11 into contact with a substrate comprising copper wiring and a resist disposed between the copper wirings, thereby removing the resist, and forming a protective layer on the surface of the copper wiring.

13. A method for removing resist, comprising a step of bringing the composition according to any one of claims 1 to 11 into contact with a substrate comprising copper wiring and a resist disposed between the copper wirings, thereby removing the resist, and forming a protective layer on the surface of the copper wiring.

14. A kit for use in the method for manufacturing an electronic substrate according to claim 12,
the kit comprising a first solution comprising a basic compound and a second solution comprising a copper surface protective agent, wherein the first and second solutions are kept in an unmixed state and mixed at the time of use.

15. A kit for use in the method for removing resist according to claim 13,
the kit comprising a first solution comprising a basic compound and a second solution comprising a copper surface protective agent, wherein the first and second solutions are kept in an unmixed state and mixed at the time of use.
